# EUROPÄISCHE PATENTANMELDUNG

(11) **EP 3 537 339 A2**
(43) Veröffentlichungstag der Anmeldung: **11.09.2019**
(21) Anmeldenummer: 19158103.2
(22) Anmeldetag: 19.02.2019
(51) Int. Cl.: G06K 9/00, G01B 11/02, G06K 9/20, G06K 9/32, G06K 7/10, B25J 9/16

(54) **KAMERA UND VERFAHREN ZUR ERFASSUNG VON BILDDATEN**

(30) Priorität: 08.03.2018 DE 102018105301
(71) Anmelder: Sick AG, 79183 Waldkirch (DE)
(72) Erfinder: Müller, Romain, 79252 Stegen (DE); Schneider, Florian, 79276 Reute (DE)

(57) **Zusammenfassung**

Es wird eine Kamera (10) mit einem Bildsensor (18) zur Erfassung von Bilddaten aus einem Erfassungsbereich (14), einem optoelektronischen Abstandssensor (24) nach dem Prinzip des Lichtlaufzeitverfahrens sowie einer mit dem Bildsensor (18) und dem Abstandssensor (18) verbundene Steuer- und Auswertungseinheit (38) angegeben. Dabei weist der Abstandssensor (24) mehrere Lichtempfangselemente (30a) auf, um ein Höhenprofil zu erzeugen, und die Steuer- und Auswertungseinheit (38) ist dafür ausgebildet, das Höhenprofil zu nutzen, um Kameraparameter zu bestimmen und/oder die Bilddaten auszuwerten.

## Beschreibung

Die Erfindung betrifft eine Kamera und ein Verfahren zur Erfassung von Bilddaten aus einem Erfassungsbereich nach dem Oberbegriff von Anspruch 1 beziehungsweise 13.

In industriellen Anwendungen werden Kameras in vielfältiger Weise eingesetzt, um Objekteigenschaften automatisch zu erfassen, beispielsweise zur Inspektion oder Vermessung von Objekten. Dabei werden Bilder des Objekts aufgenommen und entsprechend der Aufgabe durch Bildverarbeitungsverfahren ausgewertet. Eine weitere Anwendung von Kameras ist das Lesen von Codes. Mit Hilfe eines Bildsensors werden Objekte mit den darauf befindlichen Codes aufgenommen, in den Bildern die Codebereiche identifiziert und dann dekodiert. Kamerabasierte Codeleser kommen problemlos auch mit anderen Codearten als eindimensionalen Strichcodes zurecht, die wie ein Matrixcode auch zweidimensional aufgebaut sind und mehr Informationen zur Verfügung stellen. Auch die automatische Texterfassung von gedruckten Adressen (OCR, Optical Character Recognition) oder Handschriften ist im Prinzip ein Lesen von Codes. Typische Anwendungsgebiete von Codelesern sind Supermarktkassen, die automatische Paketidentifikation, Sortierung von Postsendungen, die Gepäckabfertigung in Flughäfen und andere Logistikanwendungen.

Eine häufige Erfassungssituation ist die Montage der Kamera über einem Förderband. Die Kamera nimmt während der Relativbewegung des Objektstroms auf dem Förderband Bilder auf und leitet in Abhängigkeit der gewonnenen Objekteigenschaften weitere Bearbeitungsschritte ein. Solche Bearbeitungsschritte bestehen beispielsweise in der an das konkrete Objekt angepassten Weiterverarbeitung an einer Maschine, die auf geförderte Objekte einwirkt, oder in einer Veränderung des Objektstroms, indem bestimmte Objekte im Rahmen einer Qualitätskontrolle aus dem Objektstrom ausgeschleust werden oder der Objektstrom in mehrere Teilobjektströme sortiert wird. Wenn die Kamera ein kamerabasierter Codeleser ist, werden die Objekte für eine korrekte Sortierung oder ähnliche Bearbeitungsschritte anhand der angebrachten Codes identifiziert.

Die Kamera ist vielfach Teil eines komplexen Sensorsystems. Beispielsweise ist es bei Lesetunneln an Förderbändern üblich, die Geometrie der geförderten Objekte vorab mit einem gesonderten Laserscanner zu vermessen und daraus Fokusinformationen, Auslösezeitpunkte, Bildbereiche mit Objekten und dergleichen zu bestimmen. Erst durch einen solchen Sensorverbund und eine entsprechende Steuerung wird das System intelligent und ist in der Lage, die Informationen verlässlich einzuordnen und die Informationsdichte zu erhöhen.

Als isolierter Sensor betrachtet sind herkömmliche Kameras daher mit nur geringer oder gar keiner Eigenintelligenz ausgestattet. Bekannt ist noch, einen Abstandssensor in eine Kamera zu integrieren, welcher den Abstand zu einem aufzunehmenden Objekt misst, um die Fokuslage eines Objektivs der Kamera darauf einzustellen oder eine Bildaufnahme auszulösen, falls sich ein Objekt in einem bestimmten Abstand befindet. Der Abstandssensor nutzt dafür beispielsweise ein Lichtlaufzeitverfahren (ToF, Time of Flight). Dieser einfache Abstandssensor ist aber lediglich in der Lage, einen einzigen Abstandswert frontal zur Kamera zu messen. Damit ist die Zusatzfunktionalität, die durch den Abstandssensor gewonnen werden kann, sehr überschaubar.

Es ist daher Aufgabe der Erfindung, die eigenständige Steuerung beziehungsweise Auswertung einer Kamera zu verbessern.

Diese Aufgabe wird durch eine Kamera und ein Verfahren zur Erfassung von Bilddaten aus einem Erfassungsbereich nach Anspruch 1 beziehungsweise 13 gelöst. Die Kamera nimmt mit einem Bildsensor Bilddaten aus dem Erfassungsbereich auf. Die Kamera umfasst zusätzlich zu dem Bildsensor einen optoelektronischen Abstandssensor nach dem Prinzip des Lichtlaufzeitverfahrens. Eine Steuer- und Auswertungseinheit hat Zugriff auf die Bilddaten des Bildsensors und den Abstandssensor.

Die Erfindung geht von dem Grundgedanken aus, einen ortsaufgelösten Abstandssensor einzusetzen. Dadurch steht aus mehreren Abstandsmessungen mit mehreren Lichtempfangselementen ein Höhenprofil zur Verfügung. Die Steuer- und Auswertungseinheit nutzt das Höhenprofil für die Bestimmung beziehungsweise Einstellung von Kameraparametern, als Unterstützung bei der Auswertung der Bilddaten oder auch um verschiedene Funktionen der Kamera auszulösen.

Die Erfindung hat den Vorteil, dass der Abstandssensor mit seiner Ortsauflösung oder Multizonenauswertung die Voraussetzung für eine erhöhte Eigenintelligenz schafft. Dadurch kann die Kamera in ihrer jeweiligen Anwendung Entscheidungen selbst treffen, um ihre Leistungsfähigkeit zu erhöhen oder die Qualität der Bilddaten zu verbessern. Dabei ist insbesondere möglich, autark zu entscheiden, ob Informationen der konkreten Aufnahmesituation überhaupt gesammelt werden sollen und diese Informationen auf das Wesentliche zu reduzieren. Das reduziert die Anforderungen an Bandbreite, Speicherbedarf und Rechenleistung mit besonderem Gewinn gerade dann, wenn die Kamera in ein großes System eingebunden ist (Cloud, Big Data).

Die Steuer- und Auswertungseinheit ist bevorzugt dafür ausgebildet, bei einem bestimmten Höhenprofil eine Aufnahme des Bildsensors auszulösen. Dazu erfolgt ein Vergleich beziehungsweise eine Korrelation mit einem Referenzprofil oder bestimmten Referenzcharakteristika, etwa einer mittleren Höhe, der Höhe mindestens eines zentralen Punktes innerhalb der Höhenprofile oder dergleichen, wobei eine gewisse Toleranz zugelassen bleibt. Je nach Komplexität der Vorgaben ist damit möglich, die Kamera durch Objekte in bestimmten Teilerfassungsbereichen und Abständen zu triggern, aber auch eine zumindest rudimentäre Objekterkennung realisierbar, die beispielsweise bekannte Objekte ignoriert.

Die Steuer- und Auswertungseinheit ist bevorzugt dafür ausgebildet, anhand von Informationen über ein Referenzprofil eines Behälters und des Höhenprofils zu entscheiden, ob sich ein leerer Behälter oder ein Behälter mit einem Objekt im Erfassungsbereich befindet, und davon abhängig eine Aufnahme des Bildsensors auszulösen oder nicht. Das Referenzprofil als Ganzes oder Charakteristika davon beschreiben den leeren Behälter, oder wahlweise auch den Behälter mit einem aufzunehmenden Objekt. Durch das mit dem Abstandssensor aufgenommene Höhenprofil wird nun eine Unterscheidung zwischen leeren und gefüllten Behältern möglich, und es können gezielt nur die Behälter mit Objekten aufgenommen werden. Man kann dies als Spezialfall eines Triggerns durch ein bestimmtes Höhenprofil auffassen, wobei das bestimmte Höhenprofil durch den leeren Behälter vorgegeben wird.
Die Steuer- und Auswertungseinheit ist bevorzugt dafür ausgebildet, eine Fokuslage einer Empfangsoptik des Bildsensors in Abhängigkeit von dem Höhenprofil einzustellen. Wegen der Ortsauflösung ist hierbei nicht nur eine pauschale Fokuseinstellung für einen einzigen frontal gemessenen Abstand, sondern eine optimale Einstellung für sämtliche erfassten Objektpunkte möglich. Alternativ kann ein interessierender Bereich festgelegt werden, für den aufgrund der Ortsauflösung ein passender Abstandswert bereitsteht, mit dem passend fokussiert wird.

Die Steuer- und Auswertungseinheit ist bevorzugt dafür ausgebildet, aus dem Höhenprofil die Neigung einer Fläche in dem Erfassungsbereich zu bestimmen. Die Fläche ist beispielsweise eine Grundfläche, wie ein Boden oder die Ebene eines Förderers. Dann dient die erfasste Neigung beispielsweise einer Kalibrierung. Ebenso denkbar ist aber, die Neigung mindestens einer erfassten Objektfläche zu bestimmen. Das ist eine schon für sich interessante Messgröße, die außerdem beispielsweise dafür nutzbar ist, Bilddaten perspektivisch zu entzerren.

Die Steuer- und Auswertungseinheit ist bevorzugt dafür ausgebildet, die eigene Perspektive der Kamera anhand des Höhenprofils festzustellen und/oder zu überwachen. Die Perspektive umfasst bis zu sechs Freiheitsgrade des Ortes und der Orientierung, wobei schon die Bestimmung nur eines Teils davon vorteilhaft ist, zumal die jeweilige Anwendung und Montage häufig schon Freiheitsgrade festlegt. Das Feststellen der eigenen Perspektive ist für eine Kalibration der Kamera nützlich. Mittels Überwachung wird aufgedeckt, wenn die Kamera bewegt oder angestoßen wurde, um zu warnen oder automatisch nachzukalibrieren. Dazu wird ein Referenzprofil einer Soll-Position vorgegeben oder in der anfänglichen, ausgerichteten Montageposition aufgezeichnet und damit im Betrieb verglichen. Mittelungen oder andere Filter sind sinnvoll, um nicht aus Objektbewegungen im Erfassungsbereich den Fehlschluss auf eine Kamerabewegung zu ziehen.

Die Steuer- und Auswertungseinheit ist bevorzugt dafür ausgebildet, anhand des Höhenprofils interessierende Bereiche festzulegen. Das Höhenprofil kann Eigenschaften von Objekten repräsentieren, die aufgenommen werden sollen. Besonders bevorzugt wird ein Referenzprofil eines Hintergrundes ohne interessante Objekte vorgegeben, sei es durch anfängliches Einlernen mit dem Abstandssensor oder durch eine einfache Vorgabe wie die Annahme eines ebenen Hintergrundes. Dort, wo dann im Betrieb das Höhenprofil von dem Referenzprofil abweicht, wird auf ein Objekt geschlossen und ein entsprechender interessierender Bereich festgelegt. Interessierende Bereiche können als Zusatzinformation mit ausgegeben werden, oder die Bilddaten werden schon in der Kamera zugeschnitten und so auf interessierende Bereiche beschränkt.

Das Sichtfeld des Abstandssensors liegt vorzugsweise zumindest teilweise außerhalb des Erfassungsbereichs. Das betrifft zumindest eine laterale Richtung, vorzugsweise alle relevanten lateralen Richtungen. Auf diese Weise können Vorabinformationen gewonnen werden, ehe ein Objekt sich in den Erfassungsbereich bewegt. Eine besonders bevorzugte Ausführungsform sieht ein Sichtfeld vor, das nicht neben dem Erfassungsbereich liegt, sondern größer ist und den Erfassungsbereich einschließt.

Die Kamera ist vorzugsweise stationär an einer Fördereinrichtung montiert, welche zu erfassende Objekte in einer Förderrichtung durch den Erfassungsbereich führt. Dies ist eine sehr häufige industrielle Anwendung einer Kamera. Außerdem sind die Rahmenbedingungen günstig für die einfache, verlässliche Gewinnung von Zusatzinformationen aus einem Höhenprofil. Es gibt einen bekannten, meist flachen Untergrund in festem Abstand in Form eines Förderbandes oder zumindest von Schalen oder Behältern sowie einen gleichmäßigen Objektstrom effektiv in nur einer Dimension.

Die Steuer- und Auswertungseinheit ist bevorzugt dafür ausgebildet, anhand des Höhenprofils die Geschwindigkeit von Objekten in dem Erfassungsbereich zu bestimmen. Die Geschwindigkeit umfasst allgemein Betrag und/oder Richtung, beide Komponenten können einzeln oder gemeinsam von Interesse sein. Eine einfache Richtungsbestimmung ist dadurch möglich, dass in dem Höhenprofil der Ort erfasst wird, an dem ein Objekt erstmals auftaucht. Diese eintauchende Objektkante kann auch über mehrere Erfassungen des Höhenprofils verfolgt werden, um eine Geschwindigkeit nach Betrag und Richtung zu bestimmen. Etwas aufwändiger, dafür zuverlässiger ist die zumindest zweimalige Erfassung eines Höhenprofils zu unterschiedlichen Zeitpunkten mit anschließender Korrelation von Objektbereichen, um den Verschiebevektor des Objekts und gemeinsam mit der Zeitdifferenz der Erfassungen den Geschwindigkeitsvektor zu schätzen. An einer Fördereinrichtung reduziert sich der Aufwand der Auswertung, weil nur die Richtungen vorwärts und rückwärts unterschieden werden müssen und alle Objekte mit gleichem Betrag der Geschwindigkeit gefördert werden. Es muss daher nur der Rand in Förderrichtung auf eintauchende Objekte überwacht werden, und es ist klar, in welche Richtung sich diese Objekte dann in weiteren Erfassungen des Höhenprofils bewegt haben.

Die Kamera weist bevorzugt eine Beleuchtungseinheit zum Beleuchten des Erfassungsbereichs auf, wobei die Steuer- und Auswertungseinheit dafür ausgebildet ist, die Beleuchtungseinheit anhand des Höhenprofils einzustellen. Dadurch kann für eine optimale Ausleuchtung der interessanten Objekte gesorgt werden, die Unter- wie Überbelichtung vermeidet und die quadratische Intensitätsabnahme mit zunehmendem Abstand ausgleicht.

Die Steuer- und Auswertungseinheit ist bevorzugt dafür ausgebildet, in den Bilddaten Codebereiche zu identifizieren und deren Codeinhalt auszulesen. Damit wird die Kamera zu einem kamerabasierten Codeleser für Barcodes und/oder 2D-Codes nach diversen Standards, gegebenenfalls auch für eine Texterkennung (OCR, Optical Character Reading).

Das erfindungsgemäße Verfahren kann auf ähnliche Weise weitergebildet werden und zeigt dabei ähnliche Vorteile. Derartige vorteilhafte Merkmale sind beispielhaft, aber nicht abschließend in den sich an die unabhängigen Ansprüche anschließenden Unteransprüchen beschrieben.

Die Erfindung wird nachstehend auch hinsichtlich weiterer Merkmale und Vorteile beispielhaft anhand von Ausführungsformen und unter Bezug auf die beigefügte Zeichnung näher erläutert. Die Abbildungen der Zeichnung zeigen in:
- Fig. 1: eine schematische Schnittdarstellung einer Kamera mit einem ortsaufgelösten optoelektronischen Abstandssensor;
- Fig. 2: eine dreidimensionale Ansicht einer beispielhaften Anwendung der Kamera in Montage an einem Förderband;
- Fig. 3: eine schematische Darstellung einer Kamera und ihres Sichtbereichs zur Erläuterung der Bewegungsrichtung eines Objekts;
- Fig. 4: eine schematische Darstellung einer Kamera und ihres Sichtbereichs zur Erläuterung der Winkelstellung einer erfassten Fläche;
- Fig. 5: eine schematische Darstellung einer Kamera und ihres Sichtbereichs zur Erläuterung der Bestimmung der Geschwindigkeit eines Objekts;
- Fig. 6: eine schematische Darstellung einer Kamera und ihres Sichtbereichs zur Erläuterung der Bestimmung eines interessierenden Bereichs mit einem Objekt; und
- Fig. 7: eine schematische Darstellung einer Kamera und ihres Sichtbereichs zur Erläuterung der Bestimmung eines Behälters mit oder ohne Objekt.

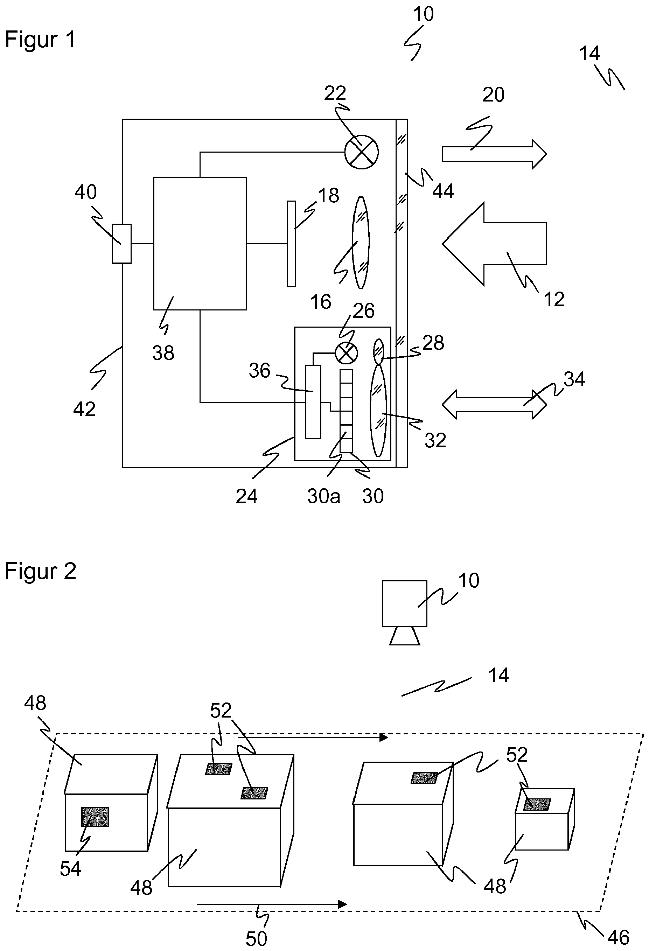

Figur 1 zeigt eine schematische Schnittdarstellung einer Kamera 10. Empfangslicht 12 aus einem Erfassungsbereich 14 trifft auf eine Empfangsoptik 16, die das Empfangslicht 12 auf einen Bildsensor 18 führt. Die optischen Elemente der Empfangsoptik 16 sind vorzugsweise als Objektiv aus mehreren Linsen und anderen optischen Elementen wie Blenden, Prismen und dergleichen ausgestaltet, hier aber vereinfachend nur durch eine Linse repräsentiert.

Um den Erfassungsbereich 14 während einer Aufnahme der Kamera 10 mit Sendelicht 20 auszuleuchten, umfasst die Kamera 10 eine optionale Beleuchtungseinheit 22, die in Figur 1 in Form einer einfachen Lichtquelle und ohne Sendeoptik dargestellt ist. In anderen Ausführungsformen sind mehrere Lichtquellen, wie LEDs oder Laserdioden, beispielsweise ringförmig um den Empfangspfad angeordnet, die auch mehrfarbig und gruppenweise oder einzeln ansteuerbar sein können, um Parameter der Beleuchtungseinheit 22 wie deren Farbe, Intensität und Richtung anzupassen.

Zusätzlich zu dem eigentlichen Bildsensor 18 zur Erfassung von Bilddaten weist die Kamera 10 einen optoelektronischen Abstandssensor 24 auf, der mit einem Lichtlaufzeitverfahren (ToF, Time of Flight) Abstände zu Objekten in dem Erfassungsbereich 14 misst. Der Abstandssensor 24 umfasst einen TOF-Lichtsender 26 mit TOF-Sendeoptik 28 sowie einen TOF-Lichtempfänger 30 mit TOF-Empfangsoptik 32. Damit wird ein TOF-Lichtsignal 34 ausgesandt und wieder empfangen. Eine Lichtlaufzeitmesseinheit 36 bestimmt die Laufzeit des TOF-Lichtsignals 34 und daraus den Abstand zu einem Objekt, an dem das TOF-Lichtsignal 34 zurückgeworfen wurde.

Der TOF-Lichtempfänger 30 weist mehrere Lichtempfangselemente 30a oder Pixel auf und ist somit ortsaufgelöst. Es wird deshalb kein einzelner Abstandswert erfasst, sondern ein ortsaufgelöstes Höhenprofil (Tiefenkarte, 3D-Bild). Dabei ist nur eine relative geringe Anzahl von Lichtempfangselementen 30a und damit laterale Auflösung des Höhenprofils vorgesehen. Es können bereits 2x2 Pixel oder sogar nur 1x2 Pixel ausreichen. Ein höher lateral aufgelöstes Höhenprofil mit nxm Pixeln, n,m > 2 lässt selbstverständlich komplexere und genauere Auswertungen zu. Die Pixelanzahl des TOF-Lichtempfängers 30 bleibt aber vergleichsweise gering mit beispielsweise einigen zehn, hundert oder tausend Pixeln beziehungsweise n,m ≤ 10, n,m ≤ 20, n,m ≤ 50 oder n,m ≤ 100, weit entfernt von üblichen Megapixelauflösungen des Bildsensors 18.

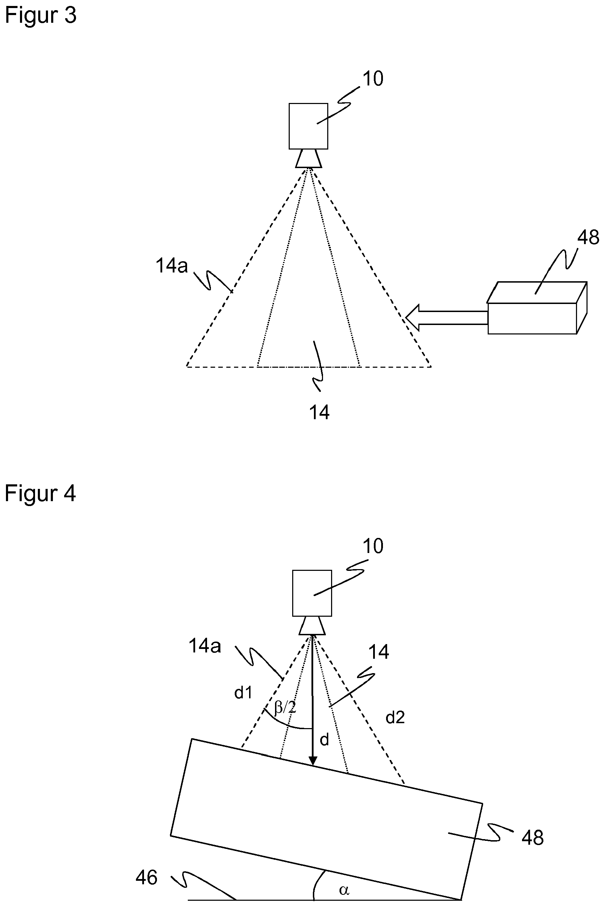

Der Aufbau des Abstandssensors 24 ist rein beispielhaft. In der weiteren Beschreibung der Erfindung unter Bezugnahme auf die Figuren 3 bis 7 wird der Abstandssensor 24 als gekapseltes Modul behandelt, welches auf Anfrage ein Höhenprofil bereitstellt. Die optoelektronische Entfernungsmessung mittels Lichtlaufzeitverfahren ist bekannt und wird daher nicht im Einzelnen erläutert. Zwei beispielhafte Messverfahren sind Photomischdetektion mit einem periodisch modulierten TOF-Lichtsignal 34 und Pulslaufzeitmessung mit einem pulsmodulierten TOF-Lichtsignal 34. Dabei gibt es auch hochintegrierte Lösungen, in denen der TOF-Lichtempfänger 30 mit der Lichtlaufzeitmesseinheit 36 oder zumindest Teilen davon, etwa TDCs (Time-to-Digital-Converter) für Laufzeitmessungen, auf einem gemeinsamen Chip untergebracht ist. Dazu eignet sich insbesondere ein TOF-Lichtempfänger 30, der als Matrix von SPAD-Lichtempfangselementen 30a aufgebaut ist (Single-Photon Avalanche Diode). Die TOF-Optiken 28, 32 sind nur symbolhaft als jeweilige Einzellinsen stellvertretend für beliebige Optiken wie beispielsweise ein Mikrolinsenfeld gezeigt.

Eine Steuer- und Auswertungseinheit 38 ist mit der Beleuchtungseinheit 22, dem Bildsensor 18 und dem Abstandssensor 38 verbunden und für die Steuerungs-, Auswertungs- und sonstigen Koordinierungsaufgaben in der Kamera 10 zuständig. Sie liest also Bilddaten des Bildsensors 18 aus, um sie zu speichern beziehungsweise an einer Schnittstelle 40 auszugeben. Das Höhenprofil des Abstandssensors 24 nutzt die Steuer- und Auswertungseinheit 38 je nach Ausführungsform für verschiedene Zwecke, etwa um Kameraparameter zu bestimmen oder einzustellen, um Kamerafunktionen auszulösen oder um Bilddaten auszuwerten, worunter auch Vorverarbeitungen für eine eigentliche Auswertung in der Kamera 10 oder einem übergeordneten System fallen. Vorzugsweise ist die Steuer- und Auswertungseinheit 38 in der Lage, Codebereiche in den Bilddaten aufzufinden und zu decodieren, womit die Kamera 10 zu einem kamerabasierten Codeleser wird.

Die Kamera 10 wird durch ein Gehäuse 42 geschützt, das im vorderen Bereich, wo das Empfangslicht 12 einfällt, durch eine Frontscheibe 44 abgeschlossen ist.

Figur 2 zeigt eine mögliche Anwendung der Kamera 10 in Montage an einem Förderband 46. Die Kamera 10 wird hier und im Folgenden nur noch als Symbol und nicht mehr mit ihrem bereits anhand der Figur 1 erläuterten Aufbau gezeigt. Das Förderband 46 fördert Objekte 48, wie durch den Pfeil 50 angedeutet, durch den Erfassungsbereich 14 der Kamera 10. Die Objekte 48 können an ihren Außenflächen Codebereiche 52 tragen. Aufgabe der Kamera 10 ist, Eigenschaften der Objekte 48 zu erfassen und in einem bevorzugten Einsatz als Codeleser die Codebereiche 52 zu erkennen, die dort angebrachten Codes auszulesen, zu dekodieren und dem jeweils zugehörigen Objekt 48 zuzuordnen. Um auch Objektseiten und insbesondere seitlich angebrachte Codebereiche 54 zu erfassen, werden vorzugsweise zusätzliche, nicht dargestellte Kameras 10 aus unterschiedlicher Perspektive eingesetzt.

Anhand der Figuren 3 bis 7 werden nun verschiedene Möglichkeiten erläutert, das Höhenprofil beziehungsweise die Multizonenauswertung des Abstandssensors 24 zu nutzen, um die Kamera 10 mit einer gewissen Eigenintelligenz auszustatten. Die Auftrennung in einzelne Figuren dient nur der Übersicht, die verschiedenen Funktionen können beliebig kombiniert werden.

Eine Anwendungsmöglichkeit ist das Regeln einer Fokusverstellung. Im Gegensatz zu einem herkömmlichen Autofokus mit einfachem Abstandssensor ermöglicht das Höhenprofil eine gezielte Fokussierung auf beliebige Ausschnitte oder die Wahl einer Fokuslage, bei der möglichst viele relevante Objektpunkte im Tiefenschärfenbereich liegen. Entsprechendes gilt für das Auslösen (Triggern) der Kamera 10, falls sich ein Objekt innerhalb eines passenden Abstandsbereichs befindet. Auch hier kann aufgrund des Höhenprofils wesentlich trennschärfer entschieden werden, ob ein Objekt tatsächlich interessant ist.

Figur 3 zeigt eine Kamera 10 über einem sich lateral in ihren Erfassungsbereich 14 bewegenden Objekt 48. Hierbei ist noch zwischen dem Erfassungsbereich 14 des Bildsensors 18 und dem Sichtbereich 14a des Abstandssensors 24 zu unterscheiden. Beide überlappen vorzugsweise deutlich, und besonders vorteilhaft ist, wenn der Abstandssensor einen größeren Sichtwinkel (Field-of-View) hat als die Kamera 10 und dadurch zumindest an einer Seite, noch bevorzugter in allen lateralen Richtungen der Sichtbereich 14a größer ist als der Erfassungsbereich 14 und diesen einschließt. Dann steht nämlich zumindest ein äußerer Rand des Höhenprofils bereits vorab der eigentlichen Aufnahme mit dem Bildsensor 18 zur Verfügung.

Das Objekt 48 kommt nun aus einer bestimmten Richtung, in diesem Fall von rechts. Das wird durch das Höhenprofil erkannt, weil der Abstandssensor 24 am rechten Rand seines Sichtbereichs 14a bei Eintritt des Objekts 48 einen kürzeren Abstand misst als zuvor. Die Kamera 10 kann nun vorbereitet, etwa eine Fokuslage oder ein Auslösezeitpunkt eingestellt werden.

Diese Richtungserkennung ist besonders vorteilhaft, wenn das Objekt 48 wie in Figur 2 auf einem Förderband 46 liegt. Dann kann unterschieden werden, ob das Förderband 46 vorwärts oder rückwärts läuft und dementsprechend ein bestimmter Modus gewählt werden, beispielsweise bei rückwärts laufendem Band die letzte Messung gelöscht werden, weil das Objekt 48 erneut eingezogen wird.

Figur 4 zeigt eine Kamera 10 über einer schrägen Fläche eines Objekts 48. Aus dem Höhenprofil kann der Neigungswinkel α der Fläche gegenüber einer Referenz wie dem Boden oder dem Förderband 46 bestimmt werden. Dazu sind trigonometrische Berechnungen oder das Vorgeben bestimmter, für einen jeweiligen Neigungswinkel charakteristischer Höhenprofile denkbar. Figur 4 illustriert beispielhaft den Sichtwinkel β des Sichtbereichs 14a, den kürzesten Abstand d und zwei Abstände d1 und d2 an den Rändern als mögliche Größen für eine trigonometrische Berechnung von α. Der Neigungswinkel α lässt sich beispielsweise nutzen, um perspektivisch zu entzerren, also aus den Bilddaten ein Bild zu erzeugen, das einer senkrechten Orientierung entspricht.

Alternativ wird nicht der Neigungswinkel α einer Fläche eines Objekts 48, sondern einer Referenzfläche bestimmt. Anders ausgedrückt wird hier die Ausrichtung der Kamera 10 selbst beispielsweise gegenüber dem Boden oder dem Förderband 46 gemessen. Das kann als Justagehilfe oder für eine anfängliche Kalibrierung der Kamera 10 nützlich sein. Die Kamera 10 kann überdies im Betrieb feststellen, ob der anfängliche Neigungswinkel α erhalten ist. Eine Veränderung wird als unerwünschter Verlust der Kalibrierung der Kamera 10 durch Stoß oder dergleichen aufgefasst und beispielsweise eine Warnung ausgegeben oder eine auch eigenständige Nachkalibrierung vorgenommen. Dabei sollte eine lediglich transiente, also durch Objekte 48 verursachte Veränderung durch einen längeren Beobachtungszeitraum, Mittelung oder andere geeignete Maßnahmen ausgeschlossen werden.

Eine solche Kalibrierhilfe und Eigenüberwachung muss auch nicht auf einer Fläche und einem einzigen Neigungswinkel α basieren. Alternativ wird ein Höhenprofil mit beliebigen statischen Gegenständen als Referenz verwendet. Auch dann ist die Kamera 10 in der Lage, eine dauerhafte Veränderung und damit eine nicht mehr vorhandene eigene Position und/oder Orientierung zu erkennen.

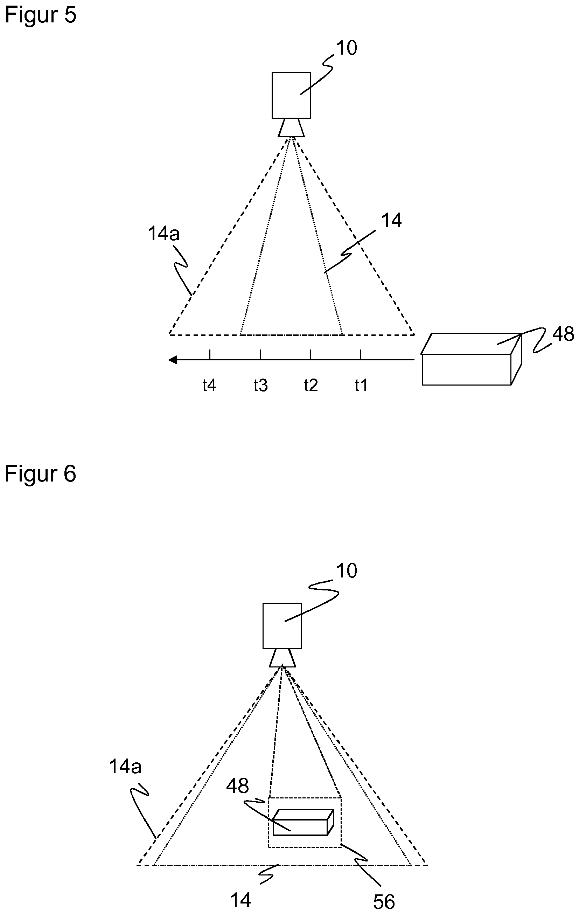

Figur 5 zeigt eine Kamera 10 über einem lateral bewegten Objekt 48 zur Erläuterung einer Geschwindigkeitsbestimmung. Dazu wird dessen Position mehrfach bestimmt, hier beispielhaft zu vier Zeitpunkten t1...t4. Unter Berücksichtigung der jeweils zwischen zwei Positionsbestimmungen verstrichenen Zeit dt und des gemessenen Abstands zu dem Objekt 48 oder eines angenommenen Abstands etwa entsprechend einer Montagehöhe der Kamera 10 lässt sich die Geschwindigkeit als Positionsänderung pro Zeit errechnen. In einer Anwendung an einem Förderband 46 ist die Auswertung vereinfacht, weil die Richtung der Bewegung bekannt ist. Alternativ wird die Richtung bei Bedarf wie zu Figur 2 erläutert in der Kamera 10 bestimmt. Durch Erfassung von Betrag und Richtung der Geschwindigkeit ist auch denkbar, untypische Bewegungen zu bemerken und auf eine mögliche Gefahrensituation hinzuweisen.

Figur 6 zeigt eine Kamera 10 über einem Objekt 48, das nur einen relativ kleinen Teilbereich des Erfassungsbereichs 14 ausfüllt. Mit Hilfe des Höhenprofils kann die Position des Objekts 48 und damit ein interessierender Bereich 56 erfasst werden. Diese Information kann die Kamera 10 selbst nutzen, um das Bild auf den interessierenden Bereich 56 zuzuschneiden beziehungsweise Codes nur dort zu suchen und damit effizienter und schneller zu arbeiten. Eine weitere Möglichkeit ist, die Bilddaten so zu belassen, aber die Information über den interessierenden Bereich 56 mit auszugeben. Das Zuschneiden hat aber den Vorteil, dass insgesamt weniger Daten anfallen.

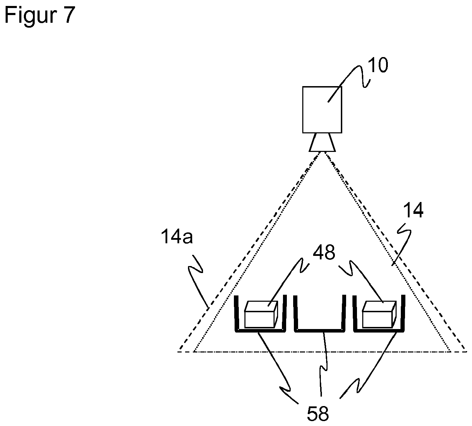

Figur 7 zeigt eine Kamera 10 über mehreren Behältern 58, in denen sich teilweise ein Objekt 48 befindet. Die Behälter 58 befinden sich je nach Situation und Anwendung gleichzeitig oder nacheinander im Erfassungsbereich 14. Anwendungsbeispiele sind ein Schalenförderer oder ein Förderband 46, auf dem Objekte 48 in Kisten befördert werden. Anhand von Referenzprofilen eines leeren Behälters 58 oder dessen charakteristischen Eigenschaften, etwa einem hohen Randbereich mit einer tieferen Fläche dazwischen, erkennt die Kamera 10, ob der jeweilige Behälter 58 ein Objekt 48 mit sich führt oder nicht. Die Kamera 10 löst dann beispielsweise nur für einen gefüllten Behälter 58 eine Aufnahme aus, oder sie legt interessierende Bereiche 56 nur um gefüllte Behälter. Eine unnötige Datenerfassung für leere Behälter 58 entfällt.

Die Behälter 58 sind ein Beispiel für eine bestimmte bekannte Umgebung, die aus dem Höhenprofil erkannt wird und in der ein Objekt 48 erfasst werden soll. Allgemein kann die Kamera 10 aus dem Höhenprofil erkennen, ob und wo sich Objekte 48 befinden, die nicht nur als Hintergrund aufgefasst werden sollen, um gezielt Aufnahmen auf relevante Situationen zu beschränken.

Eine weitere Anwendungsmöglichkeit des Höhenprofils ist die Anpassung der Beleuchtungseinheit 22. Die Beleuchtungsintensität nimmt quadratisch mit dem Abstand ab. Um dennoch einen optimalen Kontrast zu gewährleisten und Saturation zu vermeiden, kann die Beleuchtung beispielsweise durch den Strom der Beleuchtungseinheit 22, eine Blende oder die Belichtungszeit des Bildsensors 18 in Abhängigkeit von dem Höhenprofil optimiert beziehungsweise nachgeregelt werden. Es ist im Rahmen von solchen Anpassungen auch denkbar, verschiedene Beleuchtungsmodule oder Gruppen von Lichtquellen zu aktivieren oder zu deaktivieren. Damit lässt sich nicht nur ein größeres Intervall an möglichen Intensitäten abdecken, sondern die Beleuchtung sogar lokal an das Höhenprofil anpassen. Weiterhin kann auch die Intensität und Verteilung von Fremdlicht ermittelt und die Beleuchtung auch daran angepasst werden, was insbesondere bei Außenanwendungen die Bilddaten weiter verbessert.

Die Verwendung eines ortsaufgelösten Abstandssensors 24 und das interne Ausnutzen von dessen Höhenprofil für mehr Eigenintelligenz der Kamera 10 lässt sich auch auf andere Sensoren übertragen, beispielsweise Lichtschranken, Laserscanner und sogar nicht optische Sensoren.

## Patentansprüche

1. Kamera (10) mit einem Bildsensor (18) zur Erfassung von Bilddaten aus einem Erfassungsbereich (14), einem optoelektronischen Abstandssensor (24) nach dem Prinzip des Lichtlaufzeitverfahrens sowie einer mit dem Bildsensor (18) und dem Abstandssensor (18) verbundene Steuer- und Auswertungseinheit (38),
**dadurch gekennzeichnet,**
**dass** der Abstandssensor (24) mehrere Lichtempfangselemente (30a) aufweist, um ein Höhenprofil zu erzeugen, und dass die Steuer- und Auswertungseinheit (38) dafür ausgebildet ist, das Höhenprofil zu nutzen, um Kameraparameter zu bestimmen und/oder die Bilddaten auszuwerten.

2. Kamera (10) nach Anspruch 1,
wobei die Steuer- und Auswertungseinheit (38) dafür ausgebildet ist, bei einem bestimmten Höhenprofil eine Aufnahme des Bildsensors (18) auszulösen.

3. Kamera (10) nach Anspruch 1 oder 2,
wobei die Steuer- und Auswertungseinheit (38) dafür ausgebildet ist, anhand von Informationen über ein Referenzprofil eines Behälters (58) und des Höhenprofils zu entscheiden, ob sich ein leerer Behälter (58) oder ein Behälter (58) mit einem Objekt (48) im Erfassungsbereich (14) befindet, und davon abhängig eine Aufnahme des Bildsensors (18) auszulösen oder nicht.

4. Kamera (10) nach einem der vorhergehenden Ansprüche,
wobei die Steuer- und Auswertungseinheit (38) dafür ausgebildet ist, eine Fokuslage einer Empfangsoptik (16) des Bildsensors (18) in Abhängigkeit von dem Höhenprofil einzustellen.

5. Kamera (10) nach einem der vorhergehenden Ansprüche,
wobei die Steuer- und Auswertungseinheit (38) dafür ausgebildet ist, aus dem Höhenprofil die Neigung (a) einer Fläche in dem Erfassungsbereich (14) zu bestimmen.

6. Kamera (10) nach einem der vorhergehenden Ansprüche,
wobei die Steuer- und Auswertungseinheit (38) dafür ausgebildet ist, die eigene Perspektive der Kamera (10) anhand des Höhenprofils festzustellen und/oder zu überwachen.

7. Kamera (10) nach einem der vorhergehenden Ansprüche,
wobei die Steuer- und Auswertungseinheit (38) dafür ausgebildet ist, anhand des Höhenprofils interessierende Bereiche (56) festzulegen, insbesondere unter Berücksichtigung eines Referenzprofils.

8. Kamera (10) nach einem der vorhergehenden Ansprüche,
wobei das Sichtfeld (14a) des Abstandssensors (24) zumindest teilweise außerhalb des Erfassungsbereichs (14) liegt.

9. Kamera (10) nach einem der vorhergehenden Ansprüche,
die stationär an einer Fördereinrichtung (46) montiert ist, welche zu erfassende Objekte (48) in einer Förderrichtung (50) durch den Erfassungsbereich (14) führt.

10. Kamera (10) nach einem der vorhergehenden Ansprüche,
wobei die Steuer- und Auswertungseinheit (38) dafür ausgebildet ist, anhand des Höhenprofils die Geschwindigkeit von Objekten (48) in dem Erfassungsbereich (14) zu bestimmen.

11. Kamera (10) nach einem der vorhergehenden Ansprüche,
die eine Beleuchtungseinheit (22) zum Beleuchten des Erfassungsbereichs (14) aufweist, und wobei die Steuer- und Auswertungseinheit (38) dafür ausgebildet ist, die Beleuchtungseinheit (22) anhand des Höhenprofils einzustellen.

12. Kamera (10) nach einem der vorhergehenden Ansprüche,
die eine Steuer- und Auswertungseinheit (38) aufweist, die dafür ausgebildet ist, in den Bilddaten Codebereiche (52) zu identifizieren und deren Codeinhalt auszulesen.

13. Verfahren zur Erfassung von Bilddaten aus einem Erfassungsbereich (14), bei dem mit einem zusätzlichen optoelektronischen Abstandssensor (24) ein Abstand nach dem Prinzip des Lichtlaufzeitverfahrens gemessen wird,
**dadurch gekennzeichnet,**
**dass** mit dem Abstandssensor (24) ein ortsaufgelöstes Höhenprofil erzeugt und das Höhenprofil dafür genutzt wird, Aufnahmeparameter der Erfassung der Bilddaten zu bestimmen und/oder die Bilddaten auszuwerten.
